Europäisches Patentamt

European Patent Office

Office européen des brevets

(11) Publication number: **0 474 226 A2**

# EUROPEAN PATENT APPLICATION

(21) Application number: **91114962.3**

(22) Date of filing: **05.09.91**

(51) Int. Cl.5: **H03H 17/02**

(30) Priority: **06.09.90 JP 238592/90**
**22.10.90 JP 285032/90**

(43) Date of publication of application:
**11.03.92 Bulletin 92/11**

(84) Designated Contracting States:
**DE FR GB**

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Ikeda, Kazushi**
**5010, Takanoo-cho**
**Tsu-shi, Mie-ken(JP)**

(74) Representative: **Eisenführ, Speiser & Strasse**
**Martinistrasse 24**
**W-2800 Bremen 1(DE)**

(54) **Digitial filter composing apparatus and digital filter composing method therefor.**

(57) Digital filter composing apparatus, wherein a series of processings are automatically repeated, i.e., candidate functions are selected by candidate function selecting means, the frequency characteristic of the temporary transmission function is extracted, and the frequency characteristic of the temporary transmission function and the specification of frequency characteristic are compared with each other by characteristic comparing means so as to generate temporary difference information, which eliminates the manual edition of a transmission function and a trial and error decision of an adopted fundamental function.

Fig. 1

EP 0 474 226 A2

## BACKGROUND OF THE INVENTION

### 1. Field of the invention

The present invention relates to a digital filter composing apparatus for use in a digital computer and more particularly to a digital filter composing apparatus for composing the transmission function of a digital filter which satisfies an inputted specification of frequency characteristic and a digital filter composing method therefor. The present invention relates in particular to a digital filter optimizing method, provided for a digital computer, for converting the infinite word length signal flow diagram of the digital filter into a filter coefficient, the word length of a signal line or an SN ratio-optimized finite word length signal flow diagram and a digital filter optimizing system for composing an optimized digital filter circuit based on the transmission function of the digital filter.

### 2. Description of the related art

In designing a digital filter, first, a transmission function for satisfying specification of frequency characteristic decided by system design is designed. Then, the circuit of the digital filter is determined based on the transmission function, and then, a verification and an improvement are performed by simulation and finally, a hardware is achieved.

There are two approaches to the design of the transmission function. As one approach, when specification of frequency characteristic is strictly given, a specified transmission function is automatically found by using function approximating method (reference book 1: L. R. Rabiner, B. Gold: Theory and Application of Digital Signal Processing, Prentice-Hall, 1975) such as equal ripple method or window function method. This approach is capable of obtaining a transmission function in accordance with a specification, but a circuit employing the above method requires many adders and multipliers. Therefore, an apparatus comprising the circuit is manufactured at a high cost.

When a rough frequency characteristic is to be achieved, the following approach is used. According to this approach, a simple function (hereinafter referred to as fundamental function) is used to design a transmission function having "1" as the value of all coefficients or part of them "1" such as a function in which a part of coefficients so as to design an inexpensive circuit. This approach is described in Digital Signal Processing of Image written by Takahiko Ibuki and published by Nikkan Kogyo Newspaper in 1981. This book is referred to as reference book 2. The least expensive circuit is manufactured based on the design of a transmission function by using only fundamental functions. A designer determines transmission functions through trial and error by repeating the selection of transmission functions and the confirmation of frequency characteristic.

In the design of the digital filter circuit, after a transmission function having a desired frequency characteristic is determined, a signal flow diagram showing a signal flow and a calculation order is designed to achieve the transmission function as a circuit. In the initial stage of design, a filter coefficient and a signal value in the signal flow diagram are real numbers without the limitation of a word length. Three optimizations necessary for obtaining a digital signal processing circuit are described below.

(1) Coefficient quantization:

The multiplication of a signal and a filter coefficient is performed by the combination of a shift and an addition for a low cost. That is, in the signal flow diagram, the filter coefficient must be expressed by the combination of the coefficient of the n-th power of 2. The reduction of the number of additions with accuracy leads to a cost reduction. Conventional quantization of a filer coefficient is formulated if the allowable error of frequency characteristic is numerically given (R, Jain et al. Proc. IEEE Int. Conf. on Acoustics, Speech and Signal processing, p. 30.11.1, 1984). A designer determines transmission functions with experience and trial and error if frequency characteristic is rough.

(2) Determination of word length of signal:

The final word length of each signal line is determined by the simulation of a finite word length. An appropriate word length of a signal line can be estimated by a signal flow diagram. A word length may be determined according to the L1 norm of an impulse response in each signal line so that there is no unnecessary bits and that an added result does not overflow. Conventionally, in order to find an impulse response, a simulation is performed by allotting a variable which keeps a signal value to each signal line of

2

the signal flow diagram and extracting signal flows.

(3) SN ratio optimization:

A digital filter functions by quantizing coefficients and determining a word length. A negative coefficient of the minus n-th power of 2 generated by coefficient quantization becomes a noise source and transmitted noises are observed as an addition at the output port of a filter. That is, an SN ratio takes a value smaller than an ideal value. Therefore, the signal flow diagram is optimized to obtain a necessary SN ratio. Conventionally, the SN ratio is improved through trial and error by repeatedly performing the scalings of the signal flow diagram and the simulations of a finite word length.

Based on the optimized signal flow diagram, a simulation program is manually generated or the signal flow diagram is manually inputted to simulation environment as a function block diagram.

However, according to the method for designing the transmission function by using only the fundamental function, it is necessary for a designer to manually design the transmission function through trial and error by using a device for inputting the transmission function and a device for displaying frequency characteristic. Therefore, much time is required. In addition, it is difficult for an unexperienced designer to efficiently design the transmission function because much knowledge is required to select the fundamental function.

In addition, the conventional optimizing method has the following problems.

(1) Coefficient quantization

If the specification of frequency characteristic is not strictly given, there is no reference for determining the word length of a filter coefficient. In addition, the conventional method which requires a designer to find the transmission function with trial and error has a problem in efficiency.

(2) Determination of word length of signal

According to the conventional method for calculating an impulse response, it is necessary to analyze signal flows in advance to find a signal value on each signal line, which increases complexity in achieving a simulator.

(3) SN ratio optimization

SN ratio optimization method by means of the conventional simulation of a finite word length requires much time and does not necessarily reduce the circuit cost.

In addition, in design environment in which much manual operations are required to obtain the function block diagram of a digital filter based on the transmission function, it is impossible to design the transmission function in a short turnaround which is an important element in top-down design.

## SUMMARY OF THE INVENTION

Accordingly, an essential object of the present invention is to provide a digital filter composing apparatus capable of composing the transmission function of a digital filter which satisfies the specification of frequency characteristic in a short period of time and a digital filter composing method therefor.

It is another object of the present invention to provide a digital filter optimizing method for manufacturing an inexpensive circuit and automatically optimizing a signal flow diagram and a digital filter optimizing system capable of efficiently designing a digital filter based on a transmission function.

In accomplishing these and other objects, there is provided a digital filter composing apparatus comprising: specification characteristic input means for inputting the specification of frequency characteristic of a digital filter; fundamental function storing means for storing a fundamental function to be used as a constituting element of a transmission function; candidate function selecting means for selecting, from among the fundamental function, a candidate function to be used as a constituting element of a final transmission function which satisfies the specification of the frequency characteristic; transmission function storing means for storing an intermediate transmission function consisting of all fundamental functions determined as a constituting element of the final transmission function; characteristic extracting means for extracting the frequency characteristic of a temporary transmission function consisting of the candidate function and the intermediate transmission function; characteristic comparing means for generating temporary difference information by comparing the frequency characteristic of the temporary transmission function and the specification of the frequency characteristic with each other; and transmission function outputting means for outputting the final transmission function.

According to another preferred embodiment, there is provided a digital filter composing apparatus comprising: specification characteristic input means for inputting the specification of frequency characteristic of a digital filter; fundamental function storing means for storing a fundamental function to be used as a constituting element of a transmission function; candidate function selecting means for selecting, from among the fundamental function, a candidate function to be used as a constituting element of a final transmission function which satisfies the specification of the frequency characteristic; transmission function storing means for storing an intermediate transmission function consisting of all fundamental functions determined as a constituting element of the final transmission function; characteristic extracting means for extracting the frequency characteristic of a temporary transmission function consisting of the candidate function and the intermediate transmission function; characteristic comparing means for generating temporary difference information by comparing the frequency characteristic of the temporary transmission function and the specification of the frequency characteristic with each other; circuit converting means for converting the final transmission function into a digital filter circuit; and circuit outputting means for outputting the circuit diagram of the digital filter circuit.

According to the above construction, a series of processings are automatically repeated, i.e., a candidate function is selected by the candidate function selecting means, the frequency characteristic of the temporary transmission function is extracted by the characteristic extracting means, and the characteristic comparing means generates temporary difference information by comparing the frequency characteristic of the temporary transmission function and the specification of frequency characteristic with each other. Thus, an optimum transmission function of the digital filter which satisfies the specification of frequency characteristic can be composed in a short period of time.

According to still another preferred embodiment, there is provided a digital filter optimizing apparatus comprising: input/output means having a transmission function inputting section for inputting a transmission function expressed by a rational expression, a function block diagram editing section for displaying and editing the function block diagram, and a simulation result displaying section for displaying a simulated result; processing means having a signal flow diagram composing section for composing a signal flow diagram based on the transmission function, a signal flow diagram optimizing section for optimizing the signal flow, a function block mapping section for converting the signal flow diagram into the function block diagram, and a simulation section for simulating the function block diagram; and storing means for storing the transmission function, the signal flow diagram, the optimized signal flow diagram, the function block diagram, and the function block.

According to the above construction, the transmission function, the function block diagram and the like can be automatically designed. Therefore, a top-down designing can be made in a short turnaround.

A digital filter composing method in accordance with the present invention comprises a method for composing a digital filter comprising: specification characteristic inputting process for inputting the specification of frequency characteristic of the digital filter; a process for generating intermediate difference information for generating intermediate difference information by comparing the frequency characteristic of an intermediate transmission function consisting of all frequency characteristics decided as a constituting element of a final transmission function which satisfies the specification of the frequency characteristic; a first process for selecting a candidate function which reduces the intermediate difference information from among fundamental functions; a second process for extracting the frequency characteristic of a temporary transmission function consisting of the intermediate transmission function and the candidate function for each candidate function; a third process for generating temporary difference information by comparing the frequency characteristic of the temporary transmission function and the specification of the frequency characteristic with each other; a candidate function applying process for repeating the first, second, and third processes for each candidate function; an intermediate transmission function updating process for adding a candidate function which has generated a minimum temporary difference information to the intermediate transmission function; a final transmission function determining process for determining the intermediate transmission function as the final transmission function by repeatedly carrying out the process for generating intermediate difference information, the candidate function applying process, and the intermediate transmission function updating process if the intermediate difference information is less than an allowable limit; and a transmission function outputting process for outputting the final transmission function.

A method for composing a digital filter according to a further embodiment of the present invention comprises: specification characteristic inputting process for inputting the specification of frequency characteristic of the digital filter; a process for generating intermediate difference information for generating intermediate difference information by comparing the frequency characteristic of an intermediate transmission function consisting of all frequency characteristics decided as a constituting element of a final transmission function which satisfies the specification of the frequency characteristic; a first process for selecting a candidate function which reduces the intermediate difference information from among fundamental functions; a second process for extracting the frequency characteristic of a temporary transmission function consisting of the intermediate transmission function and the candidate function for each candidate function; a third process for generating temporary difference information by comparing the frequency characteristic of the temporary transmission function and the specification of the frequency characteristic with each other; a candidate function applying process for repeating the first, second, and third processes for each candidate function; an intermediate transmission function updating process for adding a candidate function which has generated a minimum temporary difference information to the intermediate transmission function; a final transmission function determining process for determining the intermediate transmission function as the final transmission function by repeatedly carrying out the process for generating intermediate difference information, the candidate function applying process, and the intermediate transmission function updating process if the intermediate difference information is less than an allowable limit; a transmission function outputting process for outputting the final transmission function; a converting process for converting the final transmission function into a digital filter circuit; and a circuit outputting process for outputting the circuit diagram of the digital filter circuit.

According to the above method, a series of processings are automatically repeated, i.e., a candidate function is selected by the candidate function selecting means, the frequency characteristic of the temporary transmission function is extracted by the characteristic extracting means, and the characteristic comparing means generates temporary difference information by comparing the frequency characteristic of the temporary transmission function and the specification of frequency characteristic with each other. Thus, an optimum transmission function of the digital filter which satisfies the specification of frequency characteristic can be composed in a short period of time.

A method for optimizing a digital filter to be carried out by using coefficient quantizing means according to the present invention comprises: a process for determining the maximum value of the word length of the digital filter coefficient; approximating process for expressing the digital filter coefficient by the ratio between an approximated integer and the n-th power of 2; resolving process for resolving the absolute value of a given integer into the sum of the n-th power of 2 closest to the integer and the remainder; factorizing process for factorizing the approximated integer expressed by the sum of the n-th power of 2 closest to the integer; dividing process for performing a division between the factorized form of the approximated integer found by the factorization performed in the factorizing process and the n-th power of 2 found in the approximating process. Thus, the resolving process is repeatedly applied to the approximated integer and the remainder resulting from the approximated integer.

A method for optimizing a digital filter to be carried out by using signal word length determining means according to the present invention has: means for updating the signal value of a signal line by inquiring of a terminal connected with the signal line on the upstream side thereof about the signal value of the terminal; terminal signal value determining means for updating the signal value of a terminal by inquiring of an operator to which the terminal belongs, a delay device or a signal line with which the terminal is connected about a signal value; calculating means consisting of a process for inquiring of the input terminal of the calculator about a signal value, a process for performing a calculation.

The above method comprises: a process for transmitting a calculated result to an output terminal; signal transmitting means for transmitting a non-updated signal value of the input terminal of the delay device to the output terminal, and an initializing process for initializing the signal flow diagram of the digital filter; signal line inquiring process for inquiring of all signal lines about signal values; a delay device inquiring process for inquiring of the input terminals of all delay devices about signal values; a signal word length calculating process for calculating the word length of the output of each adder/subtracter. Thus, the time response of the signal of the output terminal of each adder/subtracter is found by repeatedly executing the signal line inquiring process and the delay device inquiring process.

A method for optimizing a digital filter to be carried out by using SN ratio optimizing means according to the present invention comprises: a transmission function extracting process for extracting a noise transmission function from the signal flow diagram of the digital filter; an SN ratio calculating process for calculating an SN ratio; an SN ratio deciding process for deciding whether or not the SN ratio has reached a predetermined value; a noise source selecting process for searching and selecting a noise source contributing most greatly to the deterioration of the SN ratio; a scaling value calculating process for calculating the value of a scaling for the noise source; scaling value deciding process for deciding whether

EP 0 474 226 A2

or not scaling can be performed; and scaling executing process for converting the signal flow diagram by means of scaling.

According to the above method, a filter coefficient can be optimally quantized automatically, an optimum signal word length can be determined automatically, and ? can be automatically converted into an optimum circuit having a desired SN ratio. A digital filter circuit of a finite word length having a desired frequency characteristic and the SN ratio can be obtained by these processings.

**BRIEF DESCRIPTION OF THE DRAWINGS**

These and other aspects and features of the present invention will become clear from the following description taken in conjunction with the preferred embodiments thereof with reference to the accompanying drawings, in which:

Fig. 1 is a block diagram of a digital filter composing apparatus according to a first embodiment of the present invention;

Fig. 2 is a flowchart showing the operation of a characteristic extracting means according to the first embodiment;

Fig. 3 is a flowchart showing the operation of a candidate function selecting means according to the first embodiment;

Fig. 4 is a flowchart showing the operation of a circuit converting means according to the first embodiment;

Fig. 5 is a block diagram of a digital filter composing method according to a second embodiment of the present invention;

Fig. 6 is a flow diagram showing a digital filter optimizing method according to a third embodiment of the present invention;

Fig. 7 is a flow diagram showing a digital filter coefficient quantizing method according to the third embodiment;

Fig. 8 is a flow diagram showing a method for determining the signal word length of a digital filter according to the third embodiment;

Fig. 9 is a flow diagram of processing to be executed by a signal line in response to an inquiry about a signal value according to the third embodiment;

Fig. 10 is a flow diagram of processing to be executed by a terminal in response to an inquiry about a signal value according to the third embodiment;

Fig. 11 is a flow diagram of processing to be executed by a terminal in response to an inquiry about a non-updated signal value according to the third embodiment;

Fig. 12 is a flow diagram of processing to be executed by an operator in response to an inquiry about a signal value according to the third embodiment;

Figs. 13 is a flow diagram of processing to be executed by a delay device in response to an inquiry about a signal value according to the third embodiment;

Fig. 14 is a flow diagram showing a method for optimizing the SN ratio of a digital filter according to the third embodiment;

Fig. 15 is a view showing the executing rule of a scaling according to the third embodiment;

Fig. 16 is a view showing an example of a digital filter optimization according to the third embodiment;

Fig. 17 is a detailed view of a circuit of Fig. 16(b) according to the third embodiment; and

Fig. 18 is a block diagram showing the construction of a digital filter optimizing system according to the third embodiment.

**DETAILED DESCRIPTION OF THE INVENTION**

Before the description of the present invention proceeds, it is to be noted that like parts are designated by like reference numerals throughout the accompanying drawings.

The embodiment of the present invention is described below.

**First embodiment**

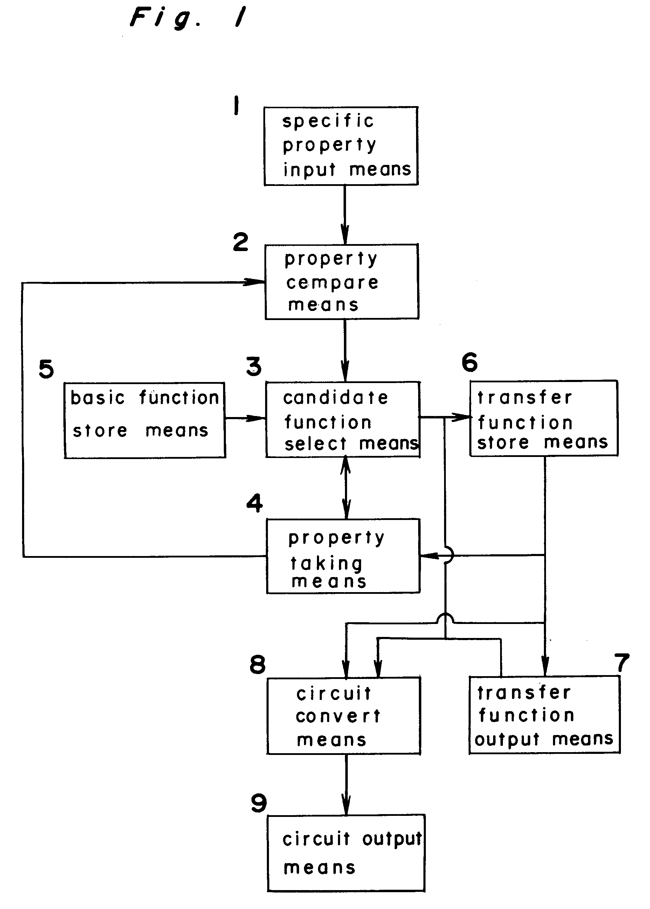

Referring to Figs. 1 through 4, a first embodiment of the present invention is described below.

Fig. 1 is a block diagram of a digital filter composing apparatus according to the first embodiment of the present invention.

A fundamental function to be used in this embodiment is a function having a simple frequency

6

characteristic in which many of coefficients are "1". For example, functions (1) and (2) as shown below are stored in fundamental function storing means 5.

where n is a positive integer and functions (1) and (2) have peaks spaced at regular intervals and a zero point on frequency axis and coefficients are all "1". Therefore, functions (1) and (2) are suitable as fundamental functions.

Specification frequency characteristic inputted by specification characteristic input means 1 must not specify frequency characteristic strictly, but specify a rough characteristic. For example, the specification of frequency characteristic is specified by parameters Fp, Aw, W, Ar as shown below.

Fp: center frequency of pass-band

Aw: attenuation amount for setting the width of pass-band

W: width of pass-band

Ar: attenuation amount of peak excluding pass-band

A transmission function in a predetermined allowable error is composed by the combination of fundamental functions for the specification of frequency characteristic specified by these parameters Fp, Aw, W, Ar.

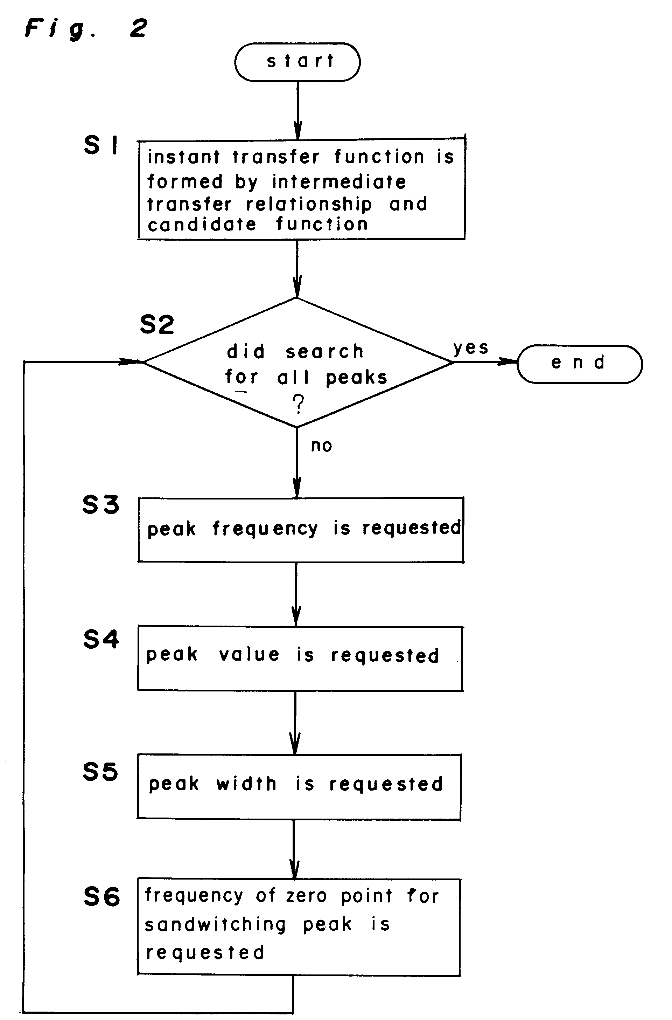

Fig. 2 is a flowchart showing the operation of characteristic extracting means 4.

As shown in Fig. 2, at step S1, characteristic extracting means 4 generates a temporary transmission function consisting of an intermediate transmission function stored in transmission function storing means 6 and a candidate function supplied from candidate function selecting means 3. In order to find the frequency of peak, the value, and the width of a peak, and the frequency of a zero point sandwiching the peak at steps S3 through S6, it is decided at step S2 whether all peaks are searched. When all peaks are searched, the frequency characteristic of the found temporary transmission function is outputted to characteristic comparing means 2.

Characteristic comparing means 2 compares the frequency characteristic of the temporary transmission function extracted by characteristic extracting means 4 and the specification of frequency characteristic with each other so as to generate the difference between the widths of pass-bands and the difference between the attenuation amounts of peaks excluding pass-band as difference information, thus outputting the difference information to candidate function selecting means 3.

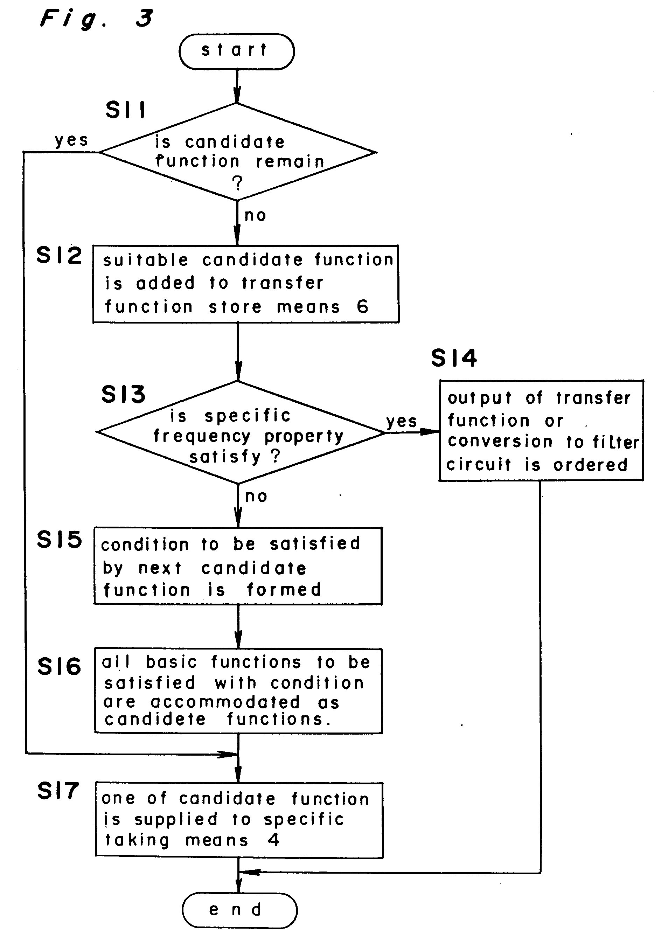

Fig. 3 is a flowchart showing the processing procedure to be executed by candidate function selecting means 3.

As shown in Fig. 3, candidate function selecting means 3 decides at step S11 whether or not candidate functions are still stored. If yes, candidate functions are sequentially supplied to characteristic extracting means 4 at step S17. If all candidate functions are not stored, candidate function selecting means 3 selects the most appropriate candidate function which has generated minimum difference information as a final transmission function, thus outputting the appropriate candidate function to transmission function storing means 6 at step S12.

It is decided at step S13 whether or not the specification of frequency characteristic is satisfied. If yes, candidate function selecting means 3 issues an instruction of the output of the transmission function to transmission function output means 7 or an instruction of a circuit conversion to circuit converting means 8 at step S14.

If no, according to intermediate difference information which is the difference information ?of the intermediate transmission function stored in transmission function storing means 6 and the frequency characteristic of the temporary transmission function extracted by characteristic extracting means 4, candidate function selecting means 3 generates the requirement (the range of frequency in which zero point should exist and the range of frequency in which zero point should not exist) to be satisfied by the following candidate function at step S15. At step S16, candidate function selecting means 3 searches all fundamental functions which satisfy the requirement from fundamental function storing means 5, thus storing them as candidate functions. Then, at step S17, candidate function selecting means 3 sequentially supplies the candidate functions to characteristic extracting means 4.

Upon receipt of the instruction of the output of the transmission function from candidate function selecting means 3, circuit converting means 8 outputs the content stored in transmission function storing means 6 as the final transmission function in the form of an equation.

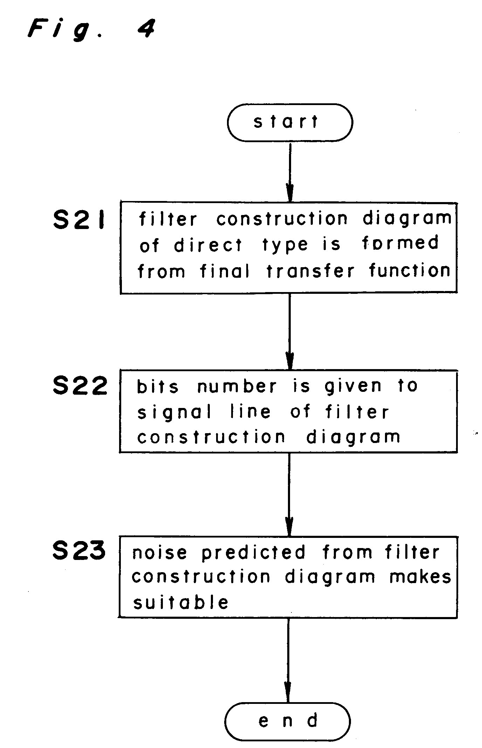

Upon receipt of the instruction of the circuit conversion from candidate function selecting means 3, circuit converting means 8 converts the content stored in transmission function storing means 6 into a digital filter circuit. Fig. 4 is a flowchart showing an example of the processing to be executed by circuit converting means 8.

As shown in Fig. 4, at step S21, circuit converting means 8 generates a direct type filter construction view from the final transmission function stored in transmission function storing means 6 (refer to reference book 1.) At step S22, circuit converting means 8 allots a minimum bit which does not cause an overflow to the signal line of the generated filter construction diagram. At step S23, circuit converting means 8 optimizes the circuit so that a ?noise transmission is below a value specified in advance (refer to reference book 1.)

Circuit output means 9 outputs the digital filter circuit generated by circuit converting means 8 as a circuit diagram.

**Second embodiment**

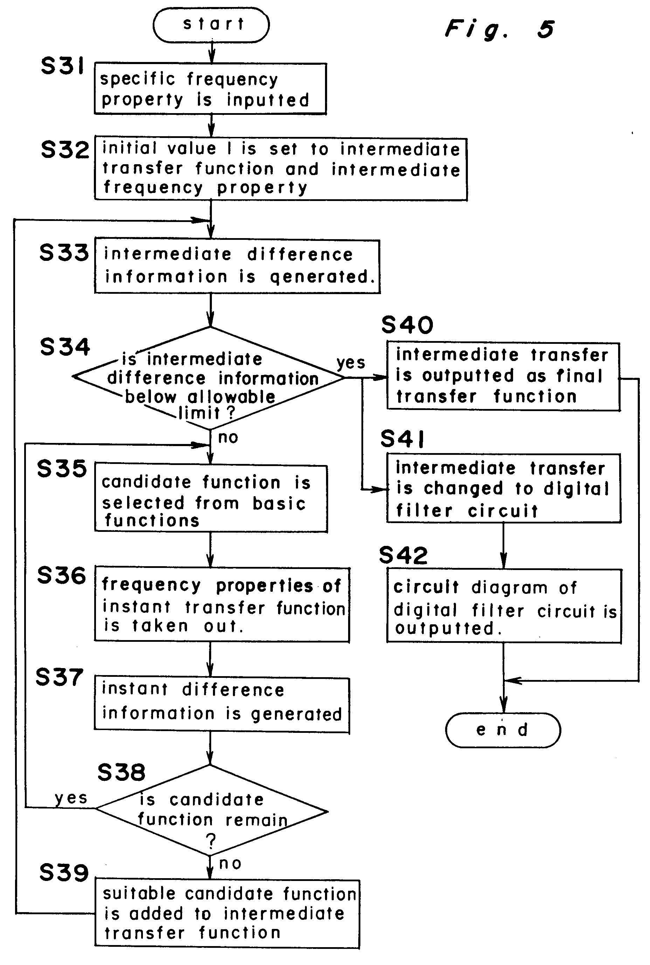

A second embodiment of the present invention is described below with reference to Fig. 5.

Fig. 5 is a flowchart showing the entire flow of a digital filter composing method according to the second embodiment of the present invention.

First, at step S31, the specification of frequency characteristic is inputted. At step S32, an initial value "1" is set for an intermediate transmission function and intermediate frequency characteristic which is the frequency characteristic thereof. At step S33, each time the intermediate transmission function is updated, the intermediate frequency characteristic and the specification of frequency characteristic are compared with each other to generate intermediate difference information. It is decided at step S34 whether or not the generated intermediate difference information is below the allowable limit. If yes, the intermediate transmission function is outputted as the final transmission function at step S40 or the intermediate transmission function is converted into a digital filter circuit at step S41 and then, the circuit diagram of the digital filter circuit is outputted at step 42.

If no, at step S34, a fundamental function which reduces the intermediate difference information is selected as a candidate function based on intermediate frequency characteristic and the intermediate difference information at step S35, and at step S36, a temporary transmission function consisting of the candidate function and the intermediate transmission function is generated to extract the frequency characteristic thereof. At step S37, the frequency characteristic of the temporary transmission function extracted at step S36 and the specification of frequency characteristic are compared with each other so as to generate temporary difference information. It is decided at step S38 whether or not stored candidate functions remain stored. If yes, the program returns to step S35 from which processings are repeated. If no, a candidate function ?having the minimum temporary difference information is added as the intermediate transmission function at step S39 and then, the program returns to step S33 from which processings are repeated.

As described above, according to the first and second embodiments, a series of processings are automatically repeated, i.e., candidate functions are selected by candidate function selecting means 3 at step S35, and the frequency characteristic of the temporary transmission function is extracted at step S36, and the frequency characteristic of the temporary transmission function and the specification of frequency characteristic are compared with each other by characteristic comparing means 2 so as to generate temporary difference information at step S37, which eliminates the manual edition of a transmission function and a trial and error decision of an adopted fundamental function. Thus, a transmission function and a digital filter circuit which satisfy the specification of frequency characteristic can be easily composed.

According to the digital filter composing apparatus and the digital filter composing method as described in the first and second embodiments, a series of processings are automatically repeated, i.e., candidate functions are selected by candidate function selecting means, and the frequency characteristic of the temporary transmission function is extracted, and the frequency characteristic of the temporary transmission function and the specification of frequency characteristic are compared with each other by characteristic comparing means so as to generate temporary difference information, which eliminates the manual edition of a transmission function and a trial and error decision of an adopted fundamental function. Thus, even an unexperienced designer can compose an appropriate transmission function of a digital filter which satisfies the specification of frequency characteristic in a short period of time.

**Third embodiment**

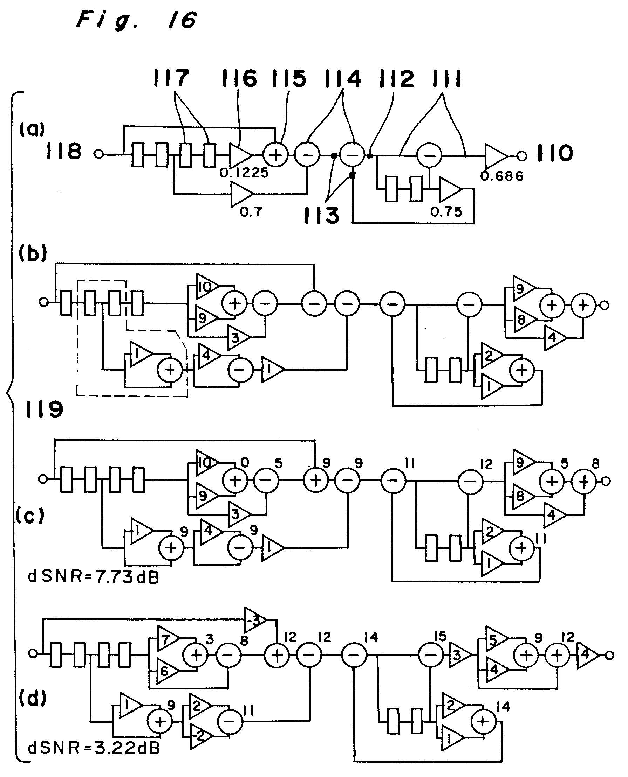

As shown in Fig. 16(a), the signal flow diagram of a digital filter which is used as the input of the SN ratio optimizing method according to a third embodiment of the present invention comprises an output port 110, an input port 118, a signal line 111, an output terminal 112, an input terminal 113, a subtracter 114, an adder 115, a coefficient multiplier 116 having a filter coefficient as a value, and a delay device 117. Hereinafter, the combination of the input terminal and the output terminal is called a terminal, the combination of the adder and the subtracter is called an adder/subtracter, and the combination of the adder/subtracter and the coefficient multiplier is called an operator. The terminal is shown for one subtracter in Fig. 16(a), but all the operators and delay devices are connected with the signal line through terminals. In the signal flow diagram, a signal value and coefficients are all indicated by real numbers.

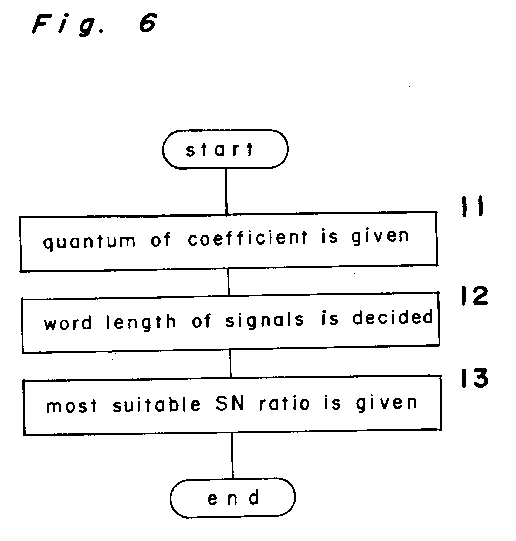

Fig. 6 is a flowchart showing the flow of the SN ratio optimizing method according to the third embodiment of the present invention. Coefficient quantizing means 11 expresses a filter coefficient given by an arbitrary real value as the sum of the coefficient of the n-th power of 2 having accuracy equivalent to the input signal of the filer. In this case, an optimum expression which minimizes the number of additions is found. In signal word length determining means 12, in finding an impulse response on the output signal line of each adder/subtracter in the signal flow diagram of the digital filter, the impulse response can be easily calculated in an arbitrary signal flow diagram by providing each constituting element with a means for updating the value of the signal line, the terminal, the operator, and the delay device. The word length of a signal is determined by L1 norm of a found impulse response. Finally, SN ratio optimizing means 13 extracts how much the coefficient of the minus n-th power of 2 which is the noise source of the signal flow diagram contributes to SN ratio and automatically obtains a desired SN ratio by sequentially performing scaling from a coefficient having a large contribution degree to a coefficient having a small contribution degree. The detailed description of each means shown in Fig. 6 is made below.

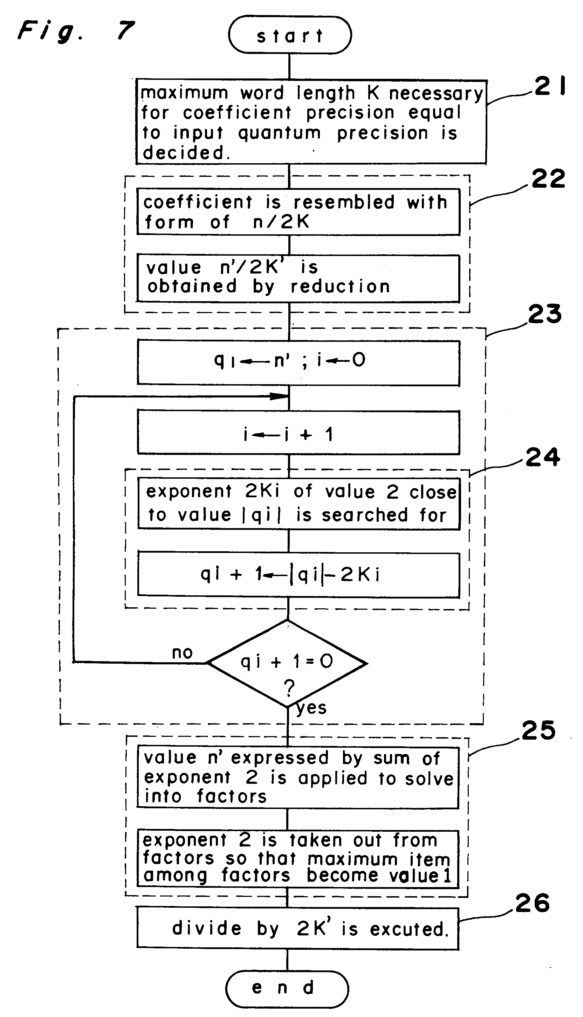

Fig. 7 is a flowchart showing the flow of the coefficient quantizing method to be carried out by the coefficient quantizing means according to the third embodiment of the present invention. In maximum coefficient word length determining process 21, supposing that the strict value of the filter coefficient is (a) and the word length of the input signal of the filter is (L), first, an input quantization error and an error made by a coefficient quantization are connected by equality as follows:

$$1/2^{L-1} = 2^{-x}/|a|$$

In the above, the integer of (x) becomes the maximum coefficient word length (k).

Then, in approximation process 22, the filer coefficient is expressed by the coefficient accuracy of $2^{-k}$. To this end, the filter coefficient (a) is approximated in the following form.

$$[a{*}2^k]_{4/5}/2^k$$

where $[\ ]_{4/5}$ shows that decimal fractions are rounded off to the unit digit. Then, a reduction is performed.

At step 23, a numerator is expanded in the sum of the n-th power of 2. In this case, resolution process 24 for resolving an integer into the n-th power of 2 closest to the integer and the remainder is repeatedly performed for an appropriate expansion which minimizes the number of terms. Then, one number of additions is reduced by factorizing an expanded expanded numerator in factorizing process 25. As an example of factorizing method, given two terms or a factorized term and other given two terms are compared with each other. If the ratio between two terms is the same, the two terms are connected with each other. A strict factorization cannot be performed by this method, but this method applies in practical use. Two to the n-th power is taken outside to increase the number of terms, the value of which is "1".

Finally, in dividing process 26, a division is performed by a denominator obtained in the above reduction so as to obtain the final form of the filter coefficient. For example, in Fig. 16(a), supposing that the word length of the input of the filter is 8 bit and the filter coefficient is 0.7, a coefficient quantization is performed as follows:

$$0.7$$

$$\to [0.7$$

$$= 45/2^6$$

$$= (32 + 16 - 2 - 1)/2^6$$

$$= 32(1 - 1/16)(1 + 1/2)/2^6$$

$$= 2^{-1}(1 - 2^{-4})(1 + 2^{-1})$$

In this example, the factorization succeeds and the number of additions/subtractions is reduced by one. As a result of the quantizations of other filter coefficients in Fig. 16(a), Fig. 16(b) is obtained. The numerical value in coefficient multiplier 116 indicates the number of powers of $2^{-1}$.

As described above, according to the coefficient quantizing method of the third embodiment, the coefficient of the digital filter can be automatically expressed by an appropriate coefficient word length and a very small number of adders, which reduces a designer's time and labor.

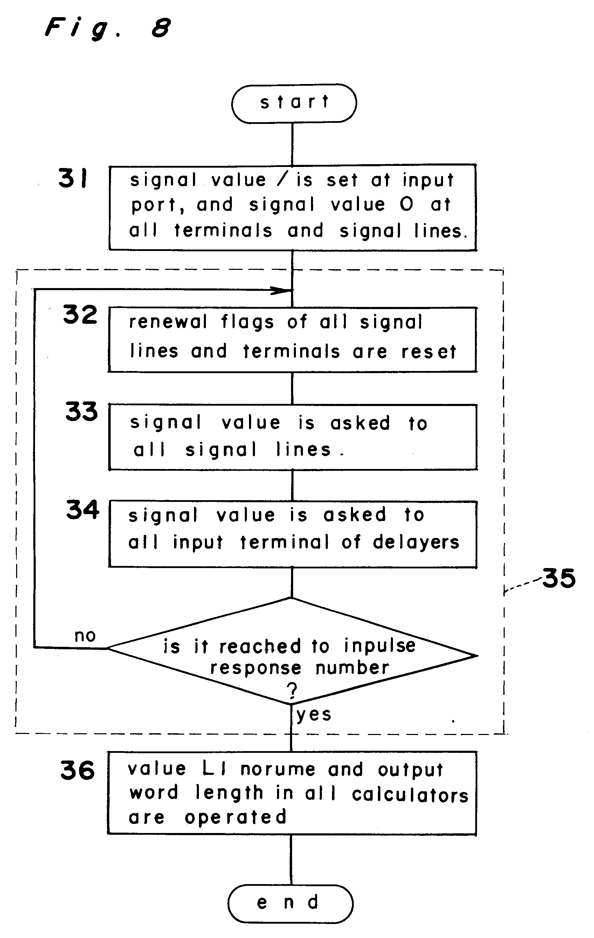

Fig. 8 is a flowchart showing the flow of the method for determining a signal word length to be carried out by the word length determining means of the third embodiment. According to the third embodiment, the composing element (input/output port, signal line, terminal, operator, delay device) of the signal flow diagram is achieved based on object-oriented scale on a software (reference book: "Guide to Object Orientation" written by Hirotaka Sakai and Kazutomo Horiuchi, 1989, published by Ohm Co., Ltd.) to make each composing element an independent object. Therefore, each composing element knows a composing element adjacent thereto and is capable of inquiring a signal value of a composing element on the upstream side or return a signal value in response to the inquiry. Fig. 8 shows processing urging these composing elements to perform autonomous operation. First, in initializing process 31, initialization is performed by setting the input port to "1" as a signal value and all the terminals and signal lines to "0" as a signal value. The following three processes are repeatedly carried out in process 35 to update the signal values of all the terminals and signal lines according to the predetermined number of impulses.

First, in resetting process 32, an updating flag showing whether or not the signal value of each signal line and terminal has been repeatedly updated in one cycle of process 35 is reset to "0". When one cycle of process 35 terminates, the updating flags of all the signal lines and terminals is set to "1".

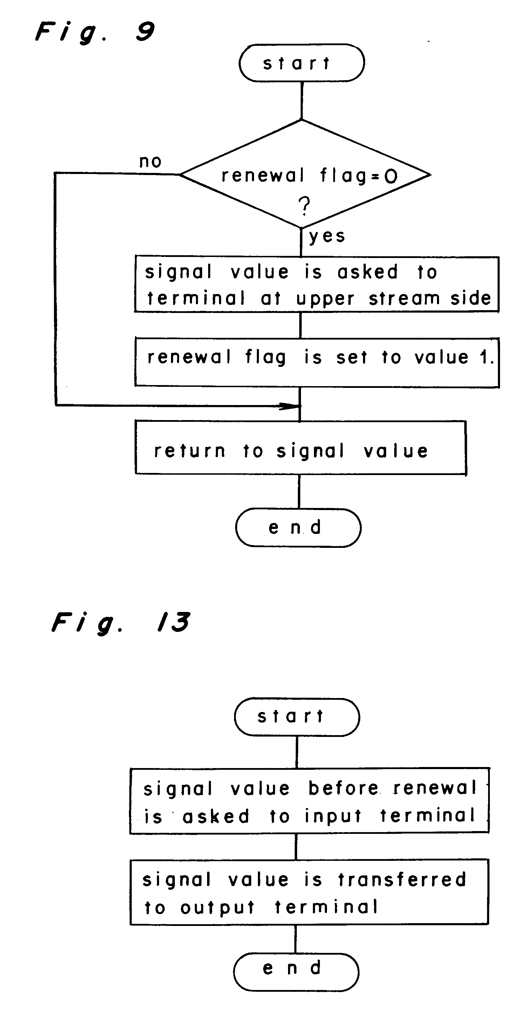

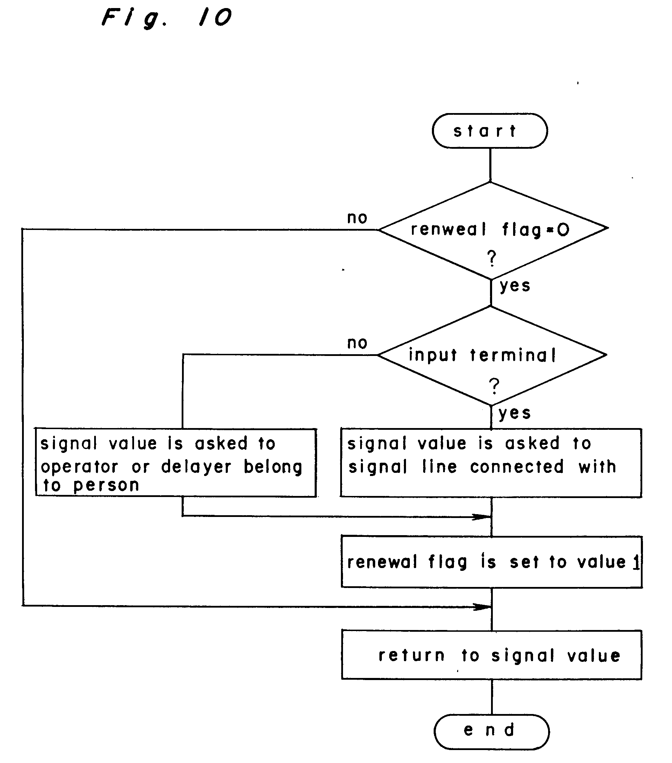

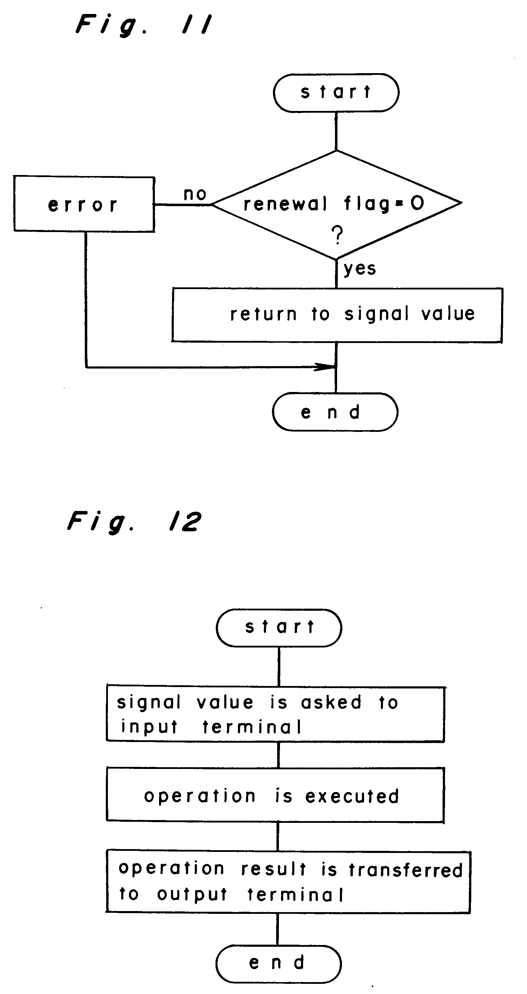

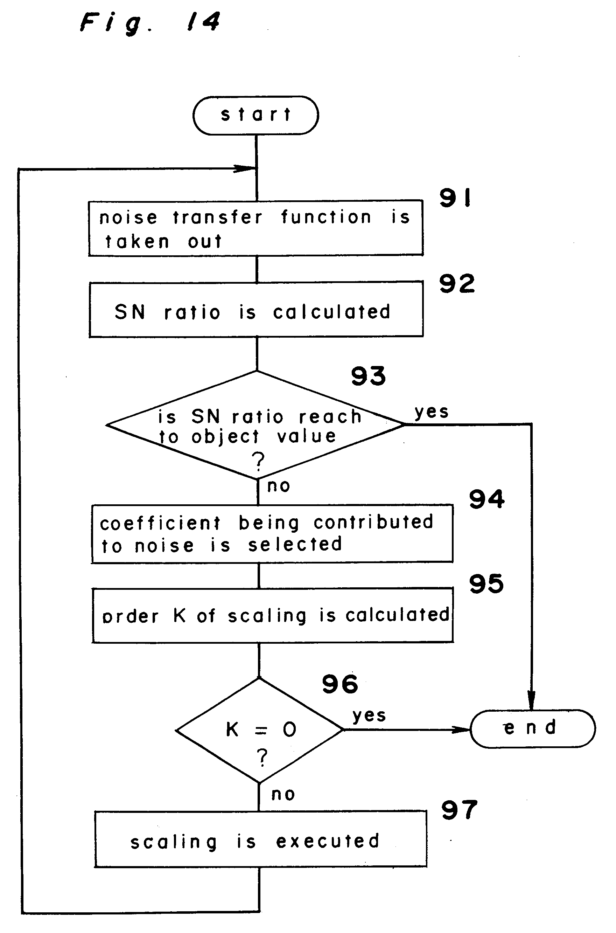

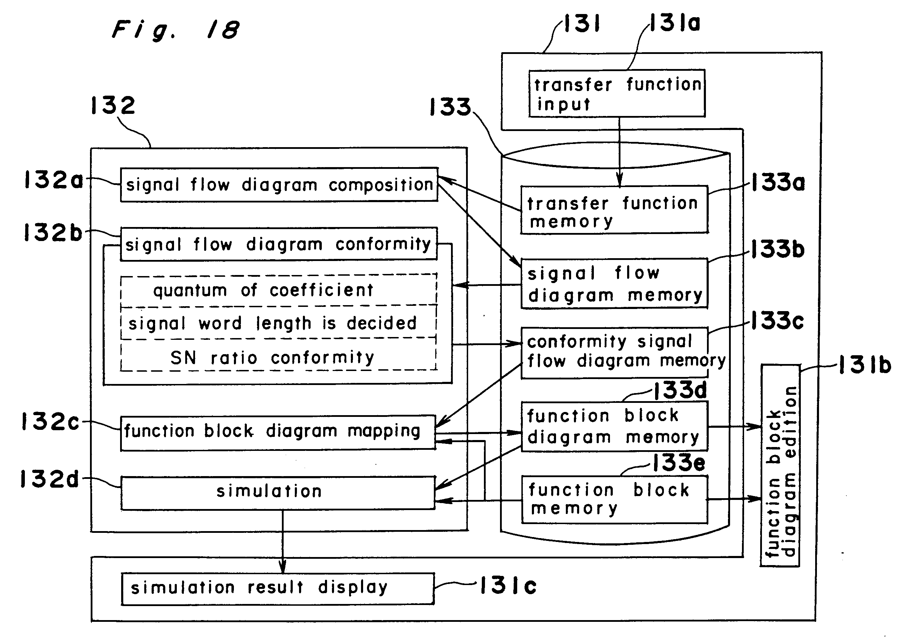

Secondly, in signal line inquiring process 33, all the signal lines are inquired about a signal value in an arbitrary order. To this end, the software has all the signal lines as an aggregated object and signal lines can be taken out one by one at a high speed. Fig. 9 is a flowchart showing the flow of the processing to be executed by the signal lines in response to the inquiry of a signal value. Fig. 10 is a flowchart showing the flow of the processing which the terminals execute in response to an inquiry about a signal value. Fig. 11 is a flowchart showing the flow of the processing which the terminals execute in response to all inquiry about a non-updated signal value. Fig. 12 is a flowchart showing the flow of the processing which the operator executes in response to an inquiry about a signal value. Fig. 13 is a flowchart showing the flow of the processing which the delay device executes in response to an inquiry about a signal value. As shown in Figs. 9 through 13, each composing element is to autonomously obtain a new signal value from a composing element on the upstream side if its signal value has not been updated. With reference to Fig. 17 which is an enlarged view of a circuit 119 shown in Fig. 16(b), how a signal value is updated is described below.

First, let it be supposed that a signal line n1 is inquired about a signal value in signal line inquiring process 33. Since the updating flag has a value "0", the signal line n1 inquires of the terminal p1 on the upstream side about a signal value before it executes processing as shown in Fig. 9. Before executing processing as shown in Fig. 10, a terminal p1 inquires of an adder c1 to which it belongs about a signal value because the updating flag has a value "0" and the terminal p1 is an output terminal. Before an adder c1 executes processing as shown in Fig. 12, it inquires of a terminal p2 about a signal value in order to perform a calculation. Since terminal P2 is an input terminal, the terminal p2 inquires of a signal line n2 about a signal value as shown in Fig. 10. Thus, the signal line n2 inquires of an output terminal p6 about a signal value and the terminal p6 inquires of a delay device c3 about a signal value. As shown in Fig. 13, the delay device c3 inquires of a terminal p7 about a non-updated signal value. Since the terminal p7 returns a non-updated signal value, it is unnecessary for the terminal p7 to inquire of a signal line on the upstream side about a signal value. Thus, the terminal p7 returns a signal value instantly according to the processing shown in Fig. 11 and the value of the updating flag remains "0". Thereafter, the delay device c3, the terminal p6, the signal line n2, the terminal p2 sequentially returns an updated signal value according to the processing shown in Figs. 13, 10, 9, and 5. As a result, the adder c1 knows one of input signals. In order to know the other input signal, the adder c1 inquires of a terminal p3 about a signal. Then, inquiries are sequentially made from the signal line n3 to a terminal p4, from the terminal p4 to a coefficient multiplier c2, from the coefficient multiplier c2 to a terminal p5, and from the terminal p5 to the signal line n2. Since the value of the updating flag is already "1" in the inquiries of signal values which start from the terminal p2 and in the updating processing, the signal line n2 returns the updated signal value as shown in Fig. 9. This signal value is sequentially transmitted from the terminal p5 to the coefficient multiplier c2, the terminal p4, the signal line n3, the terminal p3, and the adder c1. After both input signal values are obtained, the adder c1 performs an addition and memorizes the added result and returns the added result to the terminal p1 as shown in Fig. 12. The terminal p1 returns the signal value to the signal line n1 and the signal line nl sets the updating flag to "1" as shown in Fig. 9 so as to return the signal value to signal line inquiring process 33. Thus, one of the inquiries in line inquiring process 33 terminates. Accordingly, the signal values of all the composing elements are updated except the input terminal (terminal p7 in example of Fig. 17) of the input terminal by inquiring a signal value of all the signal lines.

As the third processing, all delay devices are inquired about signal values in delay device inquiring process 34. An input terminal inquires of a signal line connected therewith about a signal value according to the processing of Fig. 9. The signal values of all the signal lines have been updated in signal inquiring process 33. Therefore, the signal lines return the signal value. The input terminal to which the signal value has been returned instantly sets the value of the updating flag to "1". Thus, the signal values of all the signal lines and terminals are updated and resetting process 32 is executed again.

When process 35 has been carried out, all the adders/subtracters calculate L1 norm and a word length necessary for all output signals in signal word length calculating process 36. L1 norm is the sum of the absolute value of an impulse response. Supposing that L1 norm is N, a signal word length is expressed as follows:

(input word length of filter) $+ [\log_2 N]_{rounded\ up}$

where $[\ ]_{rounded\ up}$ means that decimal fractions are rounded up to the unit digit. The result obtained by applying the above-described signal word length determining method to Fig. 16(b) is shown in Fig. 16(c). Integers outside each adder/subtracter indicates a signal word length. The word length of "0" of some signal lines remains until the final signal word length is determined.

As described above, according to the signal word length determining method of the third embodiment, an impulse response can be found by repeating simple inquiries in any signal flow diagram and a signal word length can be easily estimated at a high speed.

Fig. 14 is a flowchart showing the flow of SN ratio optimizing method to be carried out by the SN optimizing means according to the third embodiment. If a filter coefficient is expressed by the sum of n-th power of 2 in the signal flow diagram, a noise source is expressed by an input port and the coefficient of the minus n-th power of 2. First, in transmission function extracting process 91, the noise transmission functions from the noise source to the output port are found by the tracing the signal flow diagram along the transmission direction of a signal. The value of a noise transmission function is estimated by a frequency set in advance. Then, in SN ratio calculating process 92, noises generated by all noise sources are added to each other to find a SN ratio at the output port, and it is decided by SN ratio deciding process 93 whether or not the SN ratio has attained a predetermined value. If the SN ratio has not attained the predetermined value, a coefficient having the maximum noise transmission function value, namely, a coefficient which contributes most greatly to the deterioration of SN ratio is selected in noise source selecting process 94. The order (the number of the n-th power of 2) is calculated as follows in scaling value calculating process 95. On statistical assumption, the difference $dSNR_{spec}$ between the desired value of SN ratio and an ideal value consisting of only input quantization noise is expressed as follows:

$$dSNR_{spec} = 10\log[1 + Sum|Gi|^2/|H|^2] \qquad (1)$$

where Sum is an addition symbol, Gi is a noise transmission function from i-th coefficient of M pieces of coefficients of the minus n-th power of 2 to output port, and H is the transmission function of the entire filter. The sum of the square of the absolute value of each noise transmission function in this equation is approximated as follows when all noise sources excluding coefficient immediately prior to the output port contribute to SN ratio uniformly:

$$\sum_{i=1}^{M} |Gi|^2 = 1 + (M-1)|G|^2 \quad \cdots \quad (2)$$

where G is a noise transmission function value assumed to have the same value. The ratio (s) of the value of $|G|$ found from the above equations (1) and (2) to the absolute value of an actual noise transmission function value is the scaling value. The scaling is performed by the n-th power of 2. Since the scaling is carried out by the n-th power of 2 and the scaling is not performed at a value smaller than a coefficient $2^{-n}$,

the order (the number of the n-th power of 2) of the scaling (k) is expressed as follows:

$$k = \min(n, [\log_2 s]_{\text{rounded up}}$$

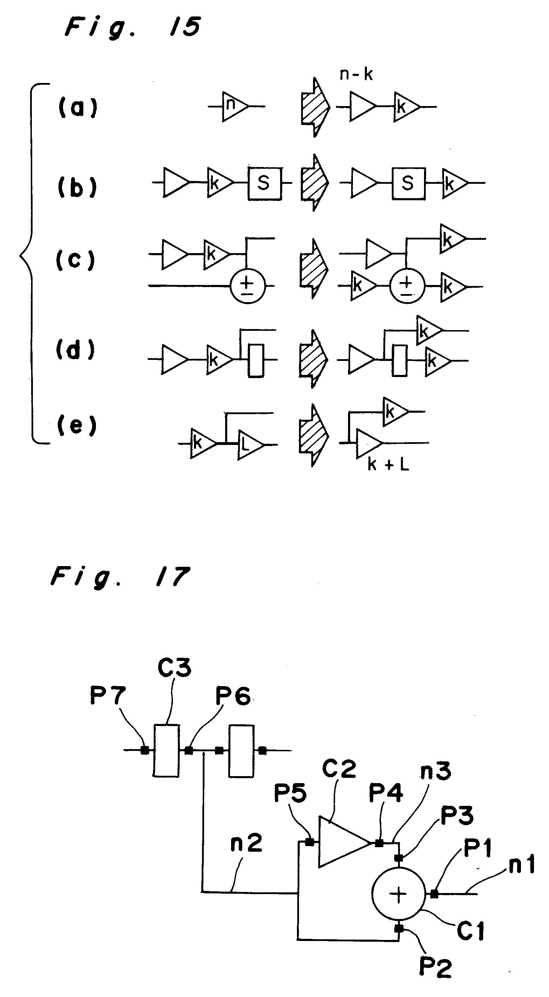

where $[\ ]_{\text{rounded up}}$ means that decimal fractions are rounded up to the unit digit. If it is decided that k is "0" in scaling value deciding process 96, SN ratio optimizing operation terminates. If it is decided that k is not "0", the scaling is carried out in scaling executing process 97 according to the rule as shown in Fig. 15. In Fig. 15, characters inside or outside a coefficient (triangle) indicate the number of the n-th powers of $2^{-1}$. In Fig. 15, S indicates a longitudinally connected section of the signal flow diagram. First, as shown in Fig. 15-(a), a coefficient $2^{-n}$ is resolved into $2^{-(n-k)}$ and $2^{-k}$. Thus, the noise from the coefficient $2^{-(n-k)}$ is attenuated by $2^{-k}$ times and a coefficient $2^{-k}$ becomes a new noise source. Then, according to the rule shown in Fig. 15(b) through 15(d), the coefficient $2^{-k}$ jumps one section, the adder/subtracter or the delay device toward the transmission direction of a signal. Figs. 15(c) and 15(d) are applied to the inside of the section. Finally, according to the rule of Fig. 15(e), continuous coefficients are connected with each other. After the execution process of scaling terminates, transmission function extracting process is carried out again. The generated noise source $2^{-k}$ as shown in Fig. 15(a) will be removed with the repeated operations shown in Fig. 14. As a result, SN ratio is improved. Fig. 16(d) is an example of SN ratio optimization of the digital filter shown in Fig. 16(c). dSNR in Figs. 16(c) and 16(d) shows the difference between SN ratio and the ideal value. $dSNR_{\text{spec}}$ is 3.3dB and the frequency for calculating a noise transmission function is 0 Hz.

As described above, according to the SN ratio optimizing method of the third embodiment, scaling is performed in the order from a noise source having the greatest noise. Therefore, a signal flow for automatically achieving a desired SN ratio is obtained at a small cost without a finite word length simulation.

Fig. 18 is a flowchart showing the construction of the digital filter optimizing system using the digital film optimizing method of the third embodiment. This system comprises an input/output means 131, processing means 132, and storing means 133. The rational function equation of a transmission function inputted to a transmission function input section 131a is stored in a transmission function memory 133a and inputted to a signal flow diagram composing section 132a, and then, a coefficient, $z^{-1}$, addition/subtraction, multiplication, and division are converted into a signal flow diagram with them corresponding to the coefficient multiplier, the delay device, the adder/subtracter, longitudinal connection, and feedback, and the signal flow diagram is stored in a signal flow diagram memory 133b as a net list indicating the connection of the operator and the delay device. For example, a transmission function shown below is converted into a signal flow diagram shown in Fig. 16(a):

$$0.688^*(1 - x^{-2})/(1 + 0.75z^{-2})\, {}^*(1 + 0.1225z^{-4} - 0.7z^{-2})$$

As an example of a net list, a coefficient multiplier having a coefficient of 0.7 is expressed as follows in the net list:

```
c100 ::: a_kind_of  :: multiplier;

input (i)  :: n5;

output (o) :: n6;

coefficient :: 0.7
```

where c100 is the name of a coefficient multipier, n5 and n6 are the names of a signal line on the input and output side, respectively, i and o are the names of input and output terminals. The signal flow diagram is inputted to a signal flow diagram optimizing section 132b and optimized by the above-described coefficient optimizing method, signal word length determining method, and SN ratio optimizing method. The above-described transmission function is optimized as shown in Fig. 16. The optimized signal flow diagram is stored by an optimizing signal flow diagram memory 133c and inputted to a function block mapping section 132c to be mapped in a function block diagram, and then, stored in a function block diagram memory 133d. An optimum signal flow diagram memory 133c and a function block diagram memory 133d store a net list similarly to the signal flow diagram memory 133b. The function block diagram includes function block diagrams having functions and attributes enough to simulate signal processing and signal lines connecting

EP 0 474 226 A2

the function blocks with each other. The function block is kept in a function block memory 133e, and attributes include, for example, the output word length of the operator, the existence/non-existence of round-off, and the existence/non-existence of saturation characteristic for an overflow. The function block diagram is displayed on a display device by a function block diagram editing section 131b. The function block diagram editing section 131b is capable of correcting the attribute of the function block diagram or altering the construction thereof. A simulation section 132d is capable of executing the simulation of a finite word length for an altered function block diagram. The simulated result is displayed on a simulation result display section 131c. Thus, the function block diagram can be improved.

As described above, according to the digital filter optimizing system of the third embodiment, the transmission function of the digital filter, the function block diagram of a finite word length and the like can be designed in a short turn-around and a top-down designing can be made without much manual labor. In particular, the digital filter optimizing method described in this embodiment is used according to Figs. 6 through 17 for the optimization of the signal flow diagram. Thus, optimization can be all automatically performed in the range from the most abstract level of the signal flow diagram circuit up to the filter circuit of a finite word length and designing can be efficiently accomplished.

According to the third embodiment, the optimization of the digital filter can be automatically accomplished in short turn-around and a digital filter circuit which satisfies a specification can be designed in a short period of time unlike the conventional method. In addition, even an unexperienced designer can a function block diagram or the like appropriately.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

**Claims**

1. A digital filter composing apparatus comprising:

specification characteristic input means for inputting the specification of frequency characteristic of a digital filter;

fundamental function storing means for storing a fundamental function to be used as a constituting element of a transmission function;

candidate function selecting means for selecting, from among said fundamental function, a candidate function to be used as a constituting element of a final transmission function which satisfies the specification of the frequency characteristic;

transmission function storing means for storing an intermediate transmission function consisting of all fundamental functions determined as a constituting element of said final transmission function;

characteristic extracting means for extracting the frequency characteristic of a temporary transmission function consisting of said candidate function and said intermediate transmission function;

characteristic comparing means for generating temporary difference information by comparing the frequency characteristic of said temporary transmission function and the specification of the frequency characteristic with each other; and

transmission function outputting means for outputting said final transmission function.

2. A digital filter composing apparatus comprising:

specification characteristic input means for inputting the specification of frequency characteristic of a digital filter;

fundamental function storing means for storing a fundamental function to be used as a constituting element of a transmission function;

candidate function selecting means for selecting, from among said fundamental function, a candidate function to be used as a constituting element of a final transmission function which satisfies the specification of the frequency characteristic;

transmission function storing means for storing an intermediate transmission function consisting of all fundamental functions determined as a constituting element of said final transmission function;

characteristic extracting means for extracting the frequency characteristic of a temporary transmission function consisting of said candidate function and said intermediate transmission function;

characteristic comparing means for generating temporary difference information by comparing the frequency characteristic of said temporary transmission function and the specification of the frequency

13

EP 0 474 226 A2

characteristic with each other;

circuit converting means for converting said final transmission function into a digital filter circuit; and

circuit outputting means for outputting the circuit diagram of said digital filter circuit.

3. A digital filter optimizing apparatus comprising:

input/output means having a transmission function inputting section for inputting a transmission function expressed by a rational expression, a function block diagram editing section for displaying and editing the function block diagram, and a simulation result displaying section for displaying a simulated result;

processing means having a signal flow diagram composing section for composing a signal flow diagram based on said transmission function, a signal flow diagram optimizing section for optimizing said signal flow, a function block mapping section for converting said signal flow diagram into the function block diagram, and a simulation section for simulating the function block diagram; and

storing means for storing the transmission function, the signal flow diagram, the optimized signal flow diagram, the function block diagram, and the function block.

4. A method for composing a digital filter comprising:

specification characteristic inputting process for inputting the specification of frequency characteristic of said digital filter;

a process for generating intermediate difference information for generating intermediate difference information by comparing the frequency characteristic of an intermediate transmission function consisting of all frequency characteristics decided as a constituting element of a final transmission function which satisfies the specification of the frequency characteristic;

a first process for selecting a candidate function which reduces said intermediate difference information from among fundamental functions;

a second process for extracting the frequency characteristic of a temporary transmission function consisting of said intermediate transmission function and said candidate function for each candidate function;

a third process for generating temporary difference information by comparing the frequency characteristic of said temporary transmission function and the specification of the frequency characteristic with each other;

a candidate function applying process for repeating said first, second, and third processes for each candidate function;

an intermediate transmission function updating process for adding a candidate function which has generated a minimum temporary difference information to said intermediate transmission function;

a final transmission function determining process for determining said intermediate transmission function as the final transmission function by repeatedly carrying out said process for generating intermediate difference information, said candidate function applying process, and said intermediate transmission function updating process if said intermediate difference information is less than an allowable limit; and

a transmission function outputting process for outputting said final transmission function.

5. A method for composing a digital filter comprising:

specification characteristic inputting process for inputting the specification of frequency characteristic of said digital filter;

a process for generating intermediate difference information for generating intermediate difference information by comparing the frequency characteristic of an intermediate transmission function consisting of all frequency characteristics decided as a constituting element of a final transmission function which satisfies the specification of the frequency characteristic;

a first process for selecting a candidate function which reduces said intermediate difference information from among fundamental functions;

a second process for extracting the frequency characteristic of a temporary transmission function consisting of said intermediate transmission function and said candidate function for each candidate function;

a third process for generating temporary difference information by comparing the frequency characteristic of said temporary transmission function and the specification of the frequency characteristic with each other;

14

a candidate function applying process for repeating said first, second, and third processes for each candidate function;

an intermediate transmission function updating process for adding a candidate function which has generated a minimum temporary difference information to said intermediate transmission function;

a final transmission function determining process for determining said intermediate transmission function as the final transmission function by repeatedly carrying out said process for generating intermediate difference information, said candidate function applying process, and said intermediate transmission function updating process if said intermediate difference information is less than an allowable limit;

a transmission function outputting process for outputting said final transmission function;

a converting process for converting said final transmission function into a digital filter circuit; and

a circuit outputting process for outputting the circuit diagram of said digital filter circuit.

6. A method for optimizing a digital filter to be carried out by using coefficient quantizing means of said method including said coefficient quantizing means, signal word length determining means, and SN ratio optimizing means comprising:

a process for determining the maximum value of the word length of said digital filter coefficient;

approximating process for expressing the digital filter coefficient by the ratio between an approximated integer and the n-th power of 2;

resolving process for resolving the absolute value of a given integer into the ?sum of the n-th power of 2 closest to the integer and the remainder;

factorizing process for factorizing said approximated integer expressed by the sum of the n-th power of 2 closest to the integer;

dividing process for performing a division between the factorized form of said approximated integer found by the factorization performed in said factorizing process and the n-th power of 2 found in said approximating process; and

whereby said resolving process is repeatedly applied to said approximated integer and the remainder resulting from said approximated integer.

7. In a method for optimizing a digital filter to be carried out by using signal word length determining means of said method including coefficient quantizing means, said signal word length determining means, and SN ratio optimizing means,

said method comprising:

means for updating the signal value of a signal line by inquiring of a terminal connected with said signal line on the upstream side thereof about the signal value of said terminal;

terminal signal value determining means for updating the signal value of a terminal by inquiring of an operator to which the terminal belongs, a delay device or a signal line with which the terminal is connected about a signal value;

calculating means consisting of a process for inquiring of the input terminal of the calculator about a signal value, a process for performing a calculation, and a process for transmitting a calculated result to an output terminal;

signal transmitting means for transmitting a non-updated signal value of the input terminal of the delay device to the output terminal, and

an initializing process for initializing the signal flow diagram of said digital filter;

signal line inquiring process for inquiring of all signal lines about signal values;

a delay device inquiring process for inquiring of the input terminals of all delay devices about signal values;

a signal word length calculating process for calculating the word length of the output of each adder/subtracter,

whereby the time response of the signal of the output terminal of each adder/subtracter is found by repeatedly executing said signal line inquiring process and said delay device inquiring process.

8. A method for optimizing a digital filter to be carried out by using SN ratio optimizing means of said method including coefficient quantizing means, signal word length determining means, and said SN ratio optimizing means comprising:

a transmission function extracting process for extracting a noise transmission function from the signal flow diagram of said digital filter;

an SN ratio calculating process for calculating an SN ratio;

an SN ratio deciding process for deciding whether or not the SN ratio has reached a predetermined value;

a noise source selecting process for searching and selecting a noise source contributing most greatly to the deterioration of the SN ratio;

a scaling value calculating process for calculating the value of a scaling for said noise source;

scaling value deciding process for deciding whether or not scaling can be performed; and

scaling executing process for converting said signal flow diagram by means of scaling.

# Fig. 1

EP 0 474 226 A2

# Fig. 2

```
                    ( start )
                        |
                        v
S1  +--------------------------------------+
    | instant transfer function is         |
    | formed by intermediate               |
    | transfer relationship and            |
    | candidate function                   |
    +--------------------------------------+
                        |
                        v
S2           did search          yes
            for all peaks    --------->  ( end )
                 ?
                        |
                        v  no
S3  +--------------------------------------+
    | peak frequency is requested          |
    +--------------------------------------+
                        |
                        v
S4  +--------------------------------------+
    | peak value is requested              |
    +--------------------------------------+
                        |
                        v
S5  +--------------------------------------+
    | peak width is requested              |
    +--------------------------------------+
                        |
                        v
S6  +--------------------------------------+
    | frequency of zero point for          |
    | sandwitching peak is                 |
    | requested                            |
    +--------------------------------------+
```

## Fig. 3

start

**SII** is candidate function remain ? — yes

no

**SI2** suitable candidate function is added to transfer function store means 6

**SI3** is specific frequency property satisfy ? — yes → **SI4** output of transfer function or conversion to filter circuit is ordered

no

**SI5** condition to be satisfied by next candidate function is formed

**SI6** all basic functions to be satisfied with condition are accommodated as candidete functions.

**SI7** one of candidate function is supplied to specific taking means 4

end

*Fig. 4*

```
              ( start )
                 |
                 v
  S21  | filter construction diagram
       | of direct type is formed
       | from final transfer function
                 |
                 v
  S22  | bits number is given to
       | signal line of filter
       | construction diagram
                 |
                 v
  S23  | noise predicted from filter
       | construction diagram makes
       | suitable
                 |
                 v
              ( end )
```

**Fig. 5**

```
                    ( start )
                       │
                       ▼
 S31  ┌─────────────────────────────┐
      │ specific frequency          │
      │ property is inputted        │
      └─────────────────────────────┘
                       │
                       ▼
 S32  ┌─────────────────────────────┐
      │ initial value I is set to   │
      │ intermediate transfer       │
      │ function and intermediate   │
      │ frequency property          │
      └─────────────────────────────┘
                       │
      ┌────────────────┤
      │                ▼
 S33  │  ┌─────────────────────────────┐
      │  │ intermediate difference     │
      │  │ information is generated.   │
      │  └─────────────────────────────┘
      │                │
      │                ▼                           S40
 S34  │      ╱ is intermediate ╲         yes  ┌─────────────────────────┐
      │     ╱ difference information ╲────────▶│ intermediate transfer   │
      │     ╲ below allowable       ╱         │ is outputted as final   │
      │      ╲    limit ?          ╱          │ transfer function       │
      │                │ no                    └─────────────────────────┘
      │                ▼                                   │
 S35  │  ┌─────────────────────────────┐       S41        ▼
      │  │ candidate function is       │       ┌─────────────────────────┐
      │  │ selected from basic         │       │ intermediate transfer   │
      │  │ functions                   │       │ is changed to digital   │
      │  └─────────────────────────────┘       │ filter circuit          │
      │                │                        └─────────────────────────┘
      │                ▼                         S42       │
 S36  │  ┌─────────────────────────────┐       ┌─────────────────────────┐
      │  │ frequency properties of     │       │ circuit diagram of      │
      │  │ instant transfer function   │       │ digital filter circuit  │
      │  │ is taken out.               │       │ is outputted.           │
      │  └─────────────────────────────┘       └─────────────────────────┘
      │                │                                   │
      │                ▼                                   │
 S37  │  ┌─────────────────────────────┐                  │
      │  │ instant difference          │                  │
      │  │ information is generated     │                  ▼
      │  └─────────────────────────────┘              ( end )
      │                │
      │                ▼
 S38  │  yes   ╱ is candidate ╲
      └───────╱ function remain ╲
              ╲      ?          ╱
                     │ no
 S39                 ▼
      ┌─────────────────────────────┐
      │ suitable candidate function │
      │ is added to intermediate    │
      │ transfer function           │
      └─────────────────────────────┘
```

*Fig. 6*

$$
\boxed{\text{start}}
$$

| 11 |
| --- |
| quantum of coefficient is given |

| 12 |
| --- |
| word length of signals is decided |

| 13 |
| --- |
| most suitable SN ratio is given |

$$
\boxed{\text{end}}
$$

*Fig. 7*

```
                    ( start )
                        |
        ┌───────────────────────────────────┐
        │ maximum word length K necessary   │── 21
        │ for coefficient precision equal   │
        │ to input quantum precision is     │
        │ decided.                          │
        └───────────────────────────────────┘
                        |
        ┌╌╌╌╌╌╌╌╌╌╌╌╌╌╌╌╌╌╌╌╌╌╌╌╌╌╌╌╌╌╌╌╌╌╌╌┐── 22
        │ ┌─────────────────────────────────┐ │
        │ │ coefficient is resembled with   │ │
        │ │ form of  n/2K                   │ │
        │ └─────────────────────────────────┘ │
        │ ┌─────────────────────────────────┐ │
        │ │ value n'/2K' is                 │ │
        │ │ obtained by reduction           │ │
        │ └─────────────────────────────────┘ │
        └╌╌╌╌╌╌╌╌╌╌╌╌╌╌╌╌╌╌╌╌╌╌╌╌╌╌╌╌╌╌╌╌╌╌╌┘
                        |                        ── 23
        ┌╌╌╌╌╌╌╌╌╌╌╌╌╌╌╌╌╌╌╌╌╌╌╌╌╌╌╌╌╌╌╌╌╌╌╌┐
        │ ┌─────────────────────────────────┐ │
        │ │     q_i ← n' ; i ← 0            │ │
        │ └─────────────────────────────────┘ │
        │ ┌─────────────────────────────────┐ │
        │ │          i ← i + 1              │ │
        │ └─────────────────────────────────┘ │
        │ ┌╌╌╌╌╌╌╌╌╌╌╌╌╌╌╌╌╌╌╌╌╌╌╌╌╌╌╌╌╌╌╌╌╌┐ │── 24
        │ │ exponent 2Ki of value 2 close   │ │
        │ │ to value |qi| is searched for   │ │
        │ │ ┌─────────────────────────────┐ │ │
        │ │ │   q_{i+1} ← |q_i| - 2^{Ki}  │ │ │
        │ │ └─────────────────────────────┘ │ │
        │ └╌╌╌╌╌╌╌╌╌╌╌╌╌╌╌╌╌╌╌╌╌╌╌╌╌╌╌╌╌╌╌╌╌┘ │
        │            /        \                │
        │    no     /  q_{i+1}=0 \             │
        │ ◄────────<      ?       >            │
        │            \          /              │
        │             \        /               │
        └╌╌╌╌╌╌╌╌╌╌╌╌╌╌╌╌ yes ╌╌╌╌╌╌╌╌╌╌╌╌╌╌╌╌┘
                        |
        ┌╌╌╌╌╌╌╌╌╌╌╌╌╌╌╌╌╌╌╌╌╌╌╌╌╌╌╌╌╌╌╌╌╌╌╌┐── 25
        │ ┌─────────────────────────────────┐ │
        │ │ value n' expressed by sum of    │ │
        │ │ exponent 2 is applied to solve  │ │
        │ │ into factors                    │ │
        │ └─────────────────────────────────┘ │
        │ ┌─────────────────────────────────┐ │
        │ │ exponent 2 is taken out from    │ │
        │ │ factors so that maximum item    │ │
        │ │ among factors become value 1    │ │
        │ └─────────────────────────────────┘ │
        └╌╌╌╌╌╌╌╌╌╌╌╌╌╌╌╌╌╌╌╌╌╌╌╌╌╌╌╌╌╌╌╌╌╌╌┘
                        |                        ── 26
        ┌─────────────────────────────────────┐
        │     divide by  2K' is excuted.      │
        └─────────────────────────────────────┘
                        |
                    ( end )
```

# Fig. 8

```
                    ┌──────────┐
                    │  start   │
                    └──────────┘
                         │
    31  ┌─────────────────────────────────────┐
        │ signal value ╱ is set at input      │
        │ port, and signal value O  at        │
        │ all terminals and signal lines.     │
        └─────────────────────────────────────┘
                         │
    ┌────────────────────┼────────────────────────────┐
    │                    ▼                             │
    │   32  ┌─────────────────────────────────────┐   │
    │       │ renewal flags of all signal         │   │
    │       │ lines and terminals are reset       │   │
    │       └─────────────────────────────────────┘   │
    │                    │                             │
    │   33  ┌─────────────────────────────────────┐   │
    │       │ signal value is asked to            │   │
    │       │ all signal lines.                   │   │
    │       └─────────────────────────────────────┘   │
    │                    │                             │
    │   34  ┌─────────────────────────────────────┐   │
    │       │ signal value is asked to            │   │
    │       │ all input terminal of delayers      │   │
    │       └─────────────────────────────────────┘   │
    │                    │                         ┆─── 35
    │    no          ◇───────────────◇            │
    └────────────── is it reached to inpulse      │
                    response number               │
                         ?                        │
                    ◇───────────────◇            │
    └────────────────────┼─yes───────────────────────┘

    36  ┌─────────────────────────────────────┐
        │ value LI norume and output          │
        │ word length in all calculators      │
        │ are operated                        │
        └─────────────────────────────────────┘
                         │
                    ┌──────────┐
                    │  e n d   │
                    └──────────┘
```

*Fig. 9*

```
        ┌─────────────┐
        │    start     │
        └─────────────┘
               │
               ▼
         ╱──────────────╲
   no   ╱  renewal flag=0 ╲
 ◀─────⟨                  ⟩
        ╲       ?        ╱
         ╲──────────────╱
               │ yes
               ▼
   ┌──────────────────────────────┐
   │  signal value is asked to     │
   │  terminal at upper stream side│
   └──────────────────────────────┘
               │
               ▼
   ┌──────────────────────────────┐
   │  renewal flag is set to value 1.│
   └──────────────────────────────┘
               │
               ▼
   ┌──────────────────────────────┐
   │   return to signal value      │
   └──────────────────────────────┘
               │
               ▼
        ┌─────────────┐
        │    end       │
        └─────────────┘
```

*Fig. 13*

```
        ┌─────────────┐
        │    start     │
        └─────────────┘
               │
               ▼
   ┌──────────────────────────────┐
   │  signal value before renewal  │
   │  is asked to input terminal   │
   └──────────────────────────────┘
               │
               ▼
   ┌──────────────────────────────┐
   │  signal value is transferred  │
   │  to output terminal           │
   └──────────────────────────────┘
               │
               ▼
        ┌─────────────┐
        │    end       │
        └─────────────┘
```

## F i g.  I0

```
                    ( start )
                        |
          no            |
    +------------ < renweal flag = O >
    |                   |      ?
    |                  yes
    |                   |
    |       no          |
    |  +--------- < input terminal >
    |  |                |     ?
    |  |               yes
    |  |                |
    | [signal value is asked to   ] [signal value is asked to  ]
    | [operator or delayer belong ] [signal line connected with]
    | [to person                  ]
    |  |                |
    |  +--------------->|
    |                   |
    |            [renewal flag is set to value 1]
    |                   |
    +------------------>|
                        |
                 [return to signal value]
                        |
                    ( end )
```

# Fig. 11

```
                              ┌─────────┐
                              │  start  │
                              └────┬────┘
                                   │
                                   ▼
        ┌─────────┐  no      ◇ renewal flag = 0 ◇
        │  error  │ ◄────────◇          ?        ◇
        └────┬────┘          ◇                    ◇
             │                        │ yes
             │                        ▼
             │         ┌──────────────────────────┐
             │         │  return to signal value  │
             │         └─────────────┬────────────┘
             │                       │
             └──────────────────────►│
                                     ▼
                              ┌─────────┐
                              │  e n d  │
                              └─────────┘
```

# Fig. 12

```
                         ┌─────────┐
                         │  start  │
                         └────┬────┘
                              │
          ┌───────────────────┴──────────────┐
          │ signal value is asked to         │
          │ input  terminal                  │
          └───────────────────┬──────────────┘
                              │
          ┌───────────────────┴──────────────┐
          │ operation  is executed           │
          └───────────────────┬──────────────┘
                              │
          ┌───────────────────┴──────────────┐
          │ operation result is transferred  │
          │ to  output  terminal             │
          └───────────────────┬──────────────┘
                              │
                         ┌────┴────┐
                         │  e n d  │
                         └─────────┘
```

## Fig. 14

Flowchart:

start

91 — noise transfer function is taken out

92 — SN ratio is calculated

93 — is SN ratio reach to object value ? — yes → end

no

94 — coefficient being contributed to noise is selected

95 — order K of scaling is calculated

96 — K = 0 ? — yes → end

no

97 — scaling is executed

Fig. 15

(a)

(b)

(c)

(d)

(e)

Fig. 17

Fig. 16

*Fig.  18*

131
131a

transfer function
input

133
132

132a — signal flow diagram composition

132b — signal flow diagram conformity

quantum of coefficient

signal word length is decided

SN ratio conformity

132c — function block diagram mapping

132d — simulation

transfer function
memory — 133a

signal flow
diagram memory — 133b

conformity signal
flow diagram memory — 133c

133d

function block
diagram memory

133e

function block
memory

131b

function block
diagram edition

simulation result display — 131c

EP 0 474 226 A2